Europäisches Patentamt

(19) European Patent Office

Office européen des brevets

(11) Numéro de publication: **0 227 491 B1**

# (12) FASCICULE DE BREVET EUROPEEN

(45) Date de publication de fascicule du brevet:
**11.09.91**

(51) Int. Cl.⁵: **G01R 31/28**

(21) Numéro de dépôt: **86402092.0**

(22) Date de dépôt: **24.09.86**

Le dossier contient des informations techniques présentées postérieurement au dépôt de la demande et ne figurant pas dans le présent fascicule.

(54) **Interface de test pour circuit intégré en technologie MOS.**

(30) Priorité: **16.10.85 FR 8515340**

(43) Date de publication de la demande:
**01.07.87 Bulletin 87/27**

(45) Mention de la délivrance du brevet:
**11.09.91 Bulletin 91/37**

(84) Etats contractants désignés:
**DE GB IT SE**

(56) Documents cités:
**EP-A- 0 141 681**
**FR-A- 2 448 724**

(73) Titulaire: **Siemens Aktiengesellschaft**
**Wittelsbacherplatz 2**
**W-8000 München 2(DE)**

(72) Inventeur: **Mate, Jean-Luc**
**11, rue Coupeau**
**F-31300 Toulouse(FR)**

(74) Mandataire: **de Boisse, Louis Arnaud et al**
**CABINET de BOISSE 37, Avenue Franklin D.**
**Roosevelt**
**F-75008 Paris(FR)**

**EP 0 227 491 B1**

## Description

La présente invention concerne les circuits intégrés réalisés en technologie MOS.

On sait que, bien souvent, les circuits intégrés sont munis d'une broche de test qui, par son activation, permet de placer le circuit intégré dans une configuration de test.

A cet égard, on connaît du document FR-A-2 448 724 un circuit en technologie MOS muni de moyens de tests conçus pour éviter l'emploi d'une broche supplémentaire de test dans le circuit. Ces moyens appliquent des signaux de test (dits de "contrôle") de polarité opposée à celle de la tension d'alimentation du circuit, à une broche qui, en fonctionnement normal, remplit une fonction différente de la fonction "test".

L'invention a pour but de fournir une interface intégrée connectée entre la broche de test et le circuit intégré et permettant de garantir une haute immunité contre les fausses manoeuvres, c'est-à-dire d'éviter que le mode de test puisse intervenir par une connexion accidentelle de la broche de test avec les broches avoisinantes du circuit intégré. L'invention vise également à fournir une telle interface qui soit fiable, ne nécessite qu'une quantité minimale de composants pour sa réalisation, et présente une faible consommation.

L'invention a donc pour objet uns interface de test pour circuit intégré du type MOS comprenant au moins une borne commune d'entrée de commande de fonction et de commande de test susceptible d'être alimentée par un signal de tension de commande de test situé hors du domaine de tensions réservé à des signaux de commande de fonction, et une borne de sortie de test, caractérisée en ce que l'interface comprend un circuit parallèle en tête-bêche des trajets source-drain de deux transistors MOS de types de conductivité opposés, ce circuit parallèle étant connecté entre une ligne de tension d'alimentation du circuit intégré et un point de potentiel qui est connecté à une source de courant sensiblement constant, la grille du premier transistor étant reliée à ladite borne d'entrée de commande de test, tandis que la grille du second transistor est reliée audit point de potentiel, et en ce que l'interface comporte en outre des moyens de détection capables, en réponse à une variation de la tension sur ledit point de potentiel due à l'application d'une tension à ladite borne d'entrée de test supérieure à ladite tension d'alimentation, de fournir une transition logique sur ladite borne de sortie de test.

Une interface répondant à ces caractéristiques présente l'avantage de nécessiter un niveau logique de commande du mode de test qui est supérieur au niveau de la tension d'alimentation maximale du circuit, ce qui élimine donc tout risque de fausses manoeuvres. Par ailleurs, le comportement de cette interface est régi dans une large mesure par les dimensions relatives des composants de sorte que son fonctionnement dépend de la précision de gravure avec laquelle le circuit peut être réalisé. Or, cette précision est très élevée dans l'état actuel de la technologie MOS.

L'invention sera mieux comprise à l'aide de la description qui va suivre de deux exemples de réalisation, en faisant référence aux dessins annexés donnés uniquement à titre d'exemple sur lesquels :

La figure 1 est un schéma de principe montrant comment l'interface de test suivant l'invention est incorporée dans un circuit intégré ;

La figure 2 est une courbe de l'état des sorties du circuit de la figure 1 en fonction de la tension VE appliquée à sa borne d'entrée ;

La figure 3 est un schéma détaillé d'un premier exemple de réalisation de l'interface de test suivant l'invention ;

La figure 4A est une représentation schématique d'un transistor MOS illustrant la définition de son facteur de forme ;

La figure 4B est une courbe caractéristique du courant de drain $I_d$ en fonction de la tension drain/source $V_{ds}$ d'un transistor MOS à connexion grille-drain commune ;

La figure 5 représente trois courbes de tensions apparaissant dans le circuit de la figure 3 au cours d'une transition l'amenant dans la configuration de test ; et

La figure 6 montre un schéma partiel d'un autre exemple de réalisation de l'invention.

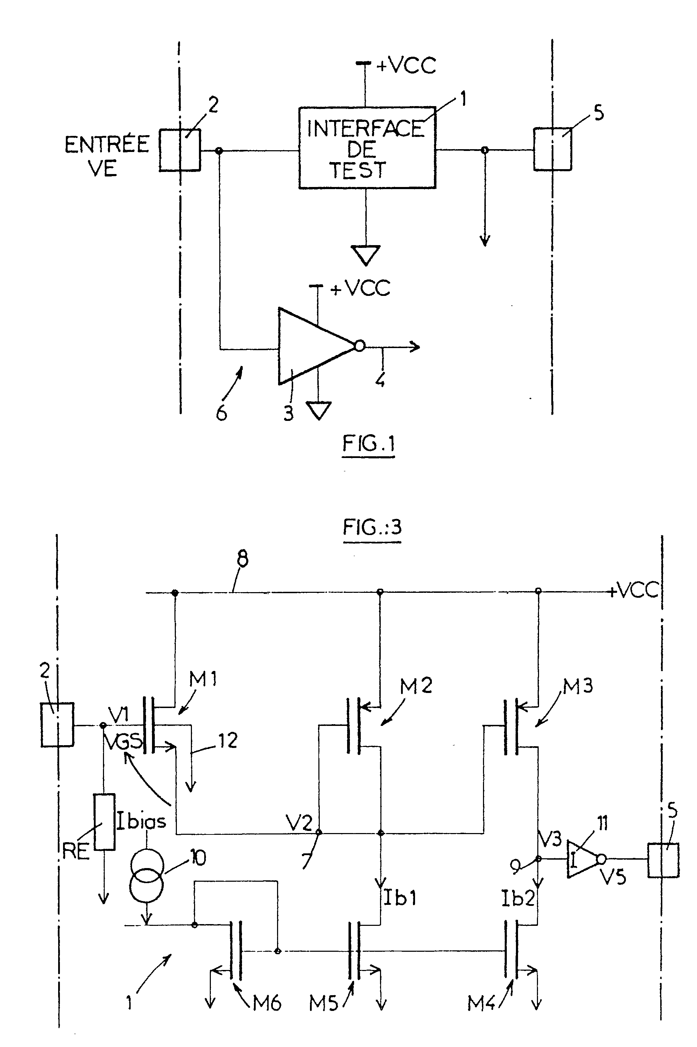

La figure 1 représente le schéma général d'un circuit intégré pourvu d'une interface de test 1 suivant l'invention.

Cette interface 1 est connectée à une borne 2 en parallèle avec un étage 3 d'entrée fonctionnelle normale du circuit intégré. L'étage 3 constitué par un inverseur présente une sortie fonctionnelle 4 connectée à d'autres parties (non représentées) du circuit intégré. La sortie de l'interface 1 peut être connectée à une borne de sortie de test 5 et pilote le passage en mode de test des parties fonctionnelles internes du circuit intégré. Le circuit intégré est désigné dans son ensemble par la référence 6.

La borne d'entrée 2 sert à la fois à activer l'étage d'entrée fonctionnelle 3 et à placer le circuit intégré 6 dans sa configuration de test. Ainsi, l'invention permet, au moyen de la même borne 2, d'appliquer sélectivement un signal fonctionnel et un signal de test au circuit intégré 6. Il est à noter toutefois que l'on pourrait éventuellement prévoir des bornes d'entrée de test et d'entrée fonctionnelle distinctes.

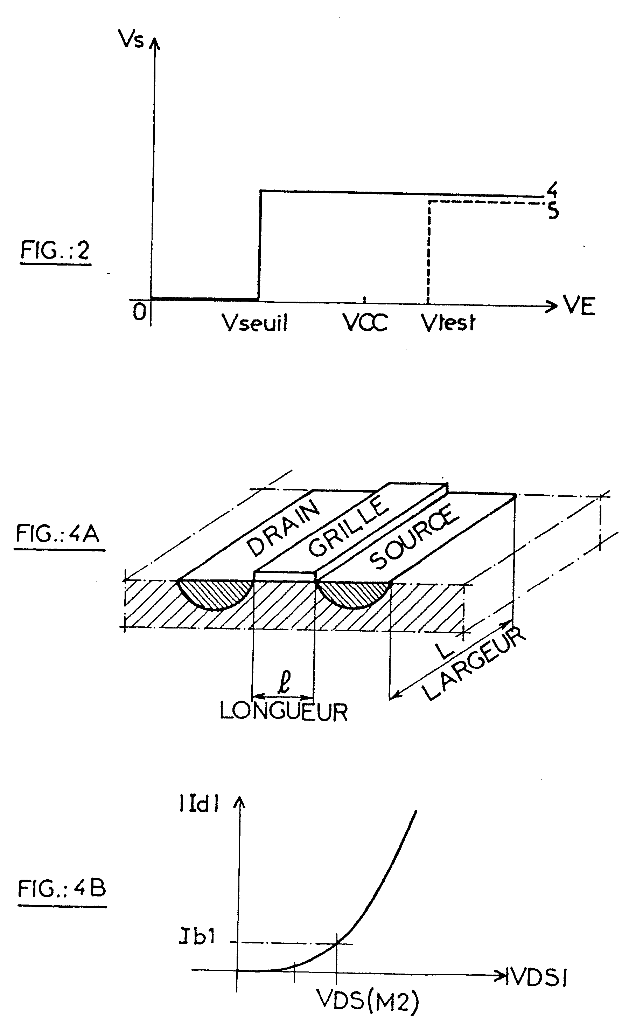

La figure 2 montre comment l'activation des sorties 4 et 5 peut être sélectionnée grâce à la présence de l'interface 1. Pour une certaine tension d'entrée $V_E$ appliquée à la borne 2, c'est-à-dire une tension $V_{seuil}$ égale à la tension de basculement de l'inverseur 3, il apparaît une transition à la sortie fonctionnelle 4 qui peut être convenablement interprétée comme une commande quelconque du circuit intégré 6.

Si, par contre, l'on applique à l'entrée 2 une tension $V_{test}$, supérieure à la tension d'alimentation $V_{cc}$ du circuit, il apparaît une transition à la sortie de test 5 permettant de placer le circuit intégré 6 dans sa configuration de test. Bien entendu, dans ce cas, le niveau logique de la sortie 4 ne varie pas. La figure 2 montre la transition de l'étage 3 en trait plein, et la transition de l'interface 1 en traits pointillés.

La figure 3 représente un schéma plus détaillé de l'interface de test 1 réalisée en technologie CMOS. L'entrée 2 qui est supposée être à la tension $V_1$ est reliée à la grille d'un premier transistor $M_1$ qui, dans cet exemple, est du type canal N à enrichissement. La source de ce transistor est reliée à un point de potentiel 7 dont la tension sera appelée $V_2$ par la suite. Le drain du transistor $M_1$ est connecté à une ligne 8 à laquelle est appliquée la tension d'alimentation $+V_{cc}$.

Le transistor $M_1$ coopère avec un autre transistor $M_2$ de type de conductivité opposée, ici donc canal P à enrichissement. La grille du transistor $M_2$ est reliée au point de potentiel 7, sa source est connectée à la ligne 8 et son drain, également au point de potentiel 7. Les trajets drain-source des transistors $M_1$ et $M_2$ forment donc un circuit parallèle tête-bêche.

Un troisième transistor $M_3$ monté en montagemiroir par rapport au transistor $M_2$ est à canal P, à enrichissement, c'est-à-dire de même type de conductivité que le transistor $M_2$. La grille du transistor $M_3$ est connectée au point de potentiel 7, sa source à la ligne 8 et son drain à un point de potentiel 9 qui est supposé être à la tension $V_3$.

Une source de courant 10 interne au circuit intégré 6 fournit un courant $I_{bias}$ à un montagemiroir de trois transistors $M_4$, $M_5$, $M_6$, tous du type de conductivité identique à celui du transistor $M_1$. Ainsi, le drain du transistor $M_4$ est connecté au point de potentiel 9, sa source est reliée à la masse et sa grille est reliée en commun aux grilles des transistors $M_5$ et $M_6$.

Les sources de ces derniers sont reliées à la masse. Le drain du transistor $M_5$ est connecté au point de potentiel 7 et celui du transistor $M_6$ est relié à la source de courant 10 et à sa propre grille.

Le point de potentiel 9 est connecté par l'intermédiaire d'un inverseur 11 à la sortie 5 qui fournit le signal logique de test.

Enfin, une résistance RE reliée entre la grille du transistor $M_1$ et la masse est destinée à ajuster l'impédance d'entrée du montage. Il est à noter que le choix d'une valeur faible pour cette résistance permet d'éviter toute transition vers le mode de test lorsque la broche 5 n'est pas connectée.

Le fonctionnement de cette interface est le suivant :

Le courant $I_{bias}$ 10 est recopié dans les transistors $M_5$ et $M_4$ sous la même forme que dans le transistor $M_6$ grâce au montage-miroir de ces trois transistors. Dans les transistors $M_4$ et $M_5$ s'écoule un courant qui dépend du facteur de forme $K_f$ des transistors en question. La définition de ce facteur de forme apparaît sur la figure 4A ; il est égal au quotient de la largeur par la longeur de la grille : $K_f = \frac{l}{L}$ . Par conséquent :

$$\frac{K_f(M_6)}{K_f(M_5)} \cdot = \frac{K_f(M_6)}{K_f(M_4)} = \frac{I_{bias}}{I_{b1}}$$

En d'autres termes, les transistors $M_4$ et $M_5$ ont sensiblement le même facteur de forme

$K_f(M_4) \neq K_f(M_5)$.

Comme le courant $I_{bias}$ est de valeur constante, il en résulte un courant $I_{b1}$ également constant circulant dans le transistor $M_5$.

Tant que le transistor $M_1$ n'est pas conducteur, parce qu'une tension insuffisante est appliquée à sa grille, ce courant $I_{b1}$ traverse en totalité le transistor MOS à canal P enrichi $M_2$. Ce transistor a sa grille reliée à son drain de sorte que la forme de sa caractéristique $I_d = f(V_{ds})$ (Figure 4B) est approximativement celle d'une diode. Le courant $I_{b1}$ impose donc aux bornes du transistor $M_2$ une chute de tension $V_{DS}(M_2) \neq V_{TP}$, $V_{DS}$ étant la tension drain-source et $V_{TP}$ étant la tension de seuil d'un transistor MOS à canal P.

Il en résulte que la tension $V_2$ au point de potentiel 7 est égale à $V_{cc} - V_{DS}(M_2) \neq V_{cc} - V_{TP}$, soit une tension très proche de la tension d'alimentation $V_{cc}$.

Les transistors $M_2$ et $M_3$ étant reliés en miroir de courant, un courant $I_{M3}$ tend à être établi dans le transistor $M_3$ de la forme :

$$I_{M3} = I_{b1} \cdot \frac{K_f(M_3)}{K_f(M_2)}$$

Si les transistors sont dimensionnés de façon que :

$$\frac{K_f(M_3)}{K_f(M_2)} > 1 \qquad alors \quad I_{M3} > I_{b1}.$$

Compte tenu de la caractéristique $I_d = f(V_{DS})$ du transistor $M_3$ et de la valeur de la tension $V_2$, ce dernier se trouve dans la zone linéaire de sa caractéristique courant-tension. Comme le rapport

$$\frac{K_f(M3)}{K_f(M2)}$$

est choisi nettement supérieur à 1 et que le courant $I_{M3}$ dans le transistor $M_3$ est égal au courant $I_{b2}$ dans le transistor $M_4$, ces deux transistors étant connectés en série, le transistor $M_3$ tend à imposer dans le transistor $M_4$ un courant supérieur à celui qui lui est assigné en raison de son montage-miroir avec les transistors $M_5$ et $M_6$. De ce fait, le transistor $M_4$ fonctionne alors dans la zone de saturation de sa caractéristique $I_d = f(V_{DS})$ et un état d'équilibre est atteint pour un courant $I_{b2}$ traversant les transistors $M_3$ et $M_4$ qui est proche de $I_{b1}$. La tension $V_3$ établie au point de potentiel 9 est donc alors proche de la tension d'alimentation $V_{cc}$.

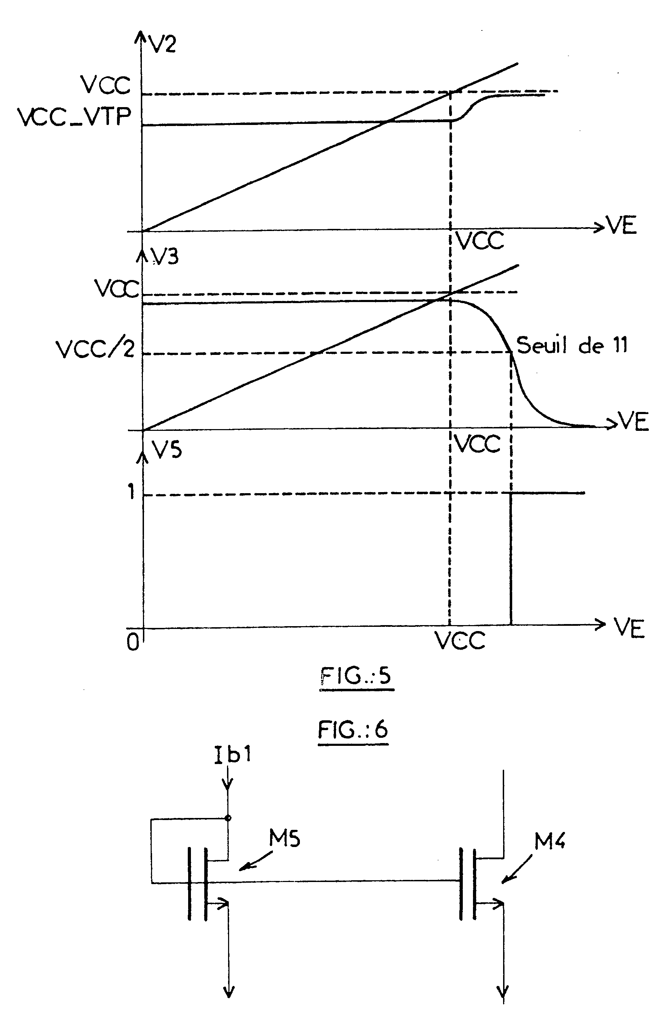

En choisissant un seuil de basculement de l'inverseur 11 ($V_{cc}/2$) qui est proche de la moitié de la tension d'alimentation, cet inverseur délivre ainsi un niveau logique O à sa sortie. Cette situation se présente tant que la tension $V_1$ appliquée à la grille du transistor $M_1$ reste inférieure ou égale à la tension d'alimentation $V_{cc}$. (Partie gauche des courbes de la Figure 5).

Le substrat ou caisson du transistor $M_1$ est connecté à la masse (connexion 12 sur la Figure 3). Sa source est reliée au potentiel du point 7 qui, comme on vient de le voir, est très proche de la tension d'alimentation $V_{cc}$:

$V_2 \neq V_{cc} - V_{TP}$

(avec par exemple $V_{TP} = 0{,}7$ V pour $V_{cc} = 5$ V)

La tension de seuil du transistor $M_1$ est donc égale à

$V'_{TN} = V_{TN} + \gamma (\sqrt{V_2 + \varnothing} - \sqrt{\varnothing})$, avec :
- $V_{TN}$ : tension de seuil d'un transistor MOS à canal N ;
- $\gamma$ : coefficient d'effet substrat situé entre 0,2 et 0,8 et typiquement 0,5;
- $\varnothing$ : constante liée à la technologie de fabrication CMOS et égale à environ 0,6 V pour les technologies actuelles.

Le seuil de conduction du transistor $M_1$ se trouve donc placé à $V_E = V_2 + V'_{TN}$ d'où il résulte :

$V_E = V_{cc} - V_{TP} + V_{TN} + \gamma(\sqrt{V_2 + \varnothing} - \sqrt{\varnothing})$

soit $V_E = V_{cc} + \Delta V_{TN}$ pour $V_{TP} \neq V_{TN}$ et TN $\gamma(\sqrt{V_2 + \varnothing} - \sqrt{\varnothing}) = \Delta V_{TN}$.

Ainsi, tant que la tension sur la grille du transistor $M_1$ reste inférieure ou égale à $V_{cc}$, l'état d'équilibre décrit ci-dessus est conservé. La tension sur la borne 2 peut donc évoluer dans cette plage pour la commande fonctionnelle du circuit intégré sans qu'il y ait risque que celui-ci soit placé dans la configuration de test.

On va maintenant examiner le cas où la borne 2 reçoit une tension supérieure à la tension d'alimentation $V_{cc}$ (partie droite des courbes de la Figure 5). Dans ce cas, le transistor $M_1$ devient conducteur et dérive une partie du courant $I_{b1}$ traversant le transistor $M_2$. Cet abaissement du courant traversant le transistor $M_2$ provoque grâce à la structure miroir une diminution du courant traversant le transistor $M_3$. Simultanément, la tension $V_2$ au point de potentiel 7 monte progressivement vers la tension $V_{cc}$ ce qui provoque une diminution de la tension grille-source du transistor $M_3$ qui passe donc de sa zone linéaire à sa zone saturée.

Comme les trajets drain-source des transistors $M_3$ et $M_4$ sont reliés en série, c'est le transistor $M_3$ et non plus la structure miroir des transistors $M_4$, $M_5$, $M_6$ qui impose le courant dans le transistor $M_4$. La tension grille-source $V_{GS}$ du transistor $M_4$ n'étant pas modifiée, la diminution du courant $I_{b2}$ qui le traverse provoque sa désaturation. Le transistor $M_4$ passe donc dans la zone linéaire de sa caractéristique $I_d$ = f-($V_{DS}$) et sa tension $V_{DS}$ (drain-source) chute, c'est-à-dire que la tension $V_3$ descend vers le potentiel de la masse comme représenté à la figure 5.

Ainsi, pour un courant d'une valeur suffisante dérivé par le transistor $M_1$ en provenance du transistor $M_5$, la tension au point de potentiel $V_3$ devient inférieure au seuil de basculement $V_{cc}/2$ de l'inverseur 11, ce qui fait passer la sortie 5 de l'interface de son niveau logique O à son niveau logique 1 ainsi que le montre la figure 5.

La valeur maximale de la tension de seuil pour laquelle l'interface bascule est déterminée par la tension maximale admissible sur la grille du transistor $M_1$, tension maximale que l'on peut par ailleurs choisir en adaptant le facteur de forme du transistor en conséquence.

La figure 6 représente une variante de l'interface suivant l'invention utilisable au cas où le circuit intégré 6 ne comporte pas lui-même une source de courant 10. On voit qu'il suffit alors de connecter ensemble la grille et le drain du transistor $M_5$, le transistor $M_6$ pouvant alors être omis. La courant $I_{b1}$ ne sera plus alors rigoureusement constant, mais cela ne modifie pas le principe de fonctionnement de l'interface 1.

Un avantage indéniable de l'interface de test décrite est qu'elle ne nécessite pas l'adjonction d'une broche d'entrée de test spécifique au circuit intégré qui l'incorpore puisque cette interface peut être connectée en parallèle avec un étage d'entrée fonctionnelle normale de ce circuit (Figure 1).

En effet, le seuil de cet étage d'entrée fonctionnelle normale se trouve situé entre zéro et le potentiel d'alimentation $V_{cc}$ du circuit intégré. Pour cette gamme de potentiel d'entrée, l'interface de test est inactive et ne perturbe pas le fonctionnement du circuit intégré. En portant la tension d'entrée $V_E$ à la borne 2 au-delà de la tension d'alimentation $V_{cc}$, on procède à l'activation de l'interface de test sans modification du niveau logique de l'étage d'entrée 3.

On remarquera que les deux états que peut prendre l'interface dépendent en grande partie des facteurs de forme des transistors MOS utilisés, c'est-à-dire essentiellement du dimensionnement des grilles qui peuvent être réalisées avec une très haute précision. On peut donc facilement maîtriser le comportement de l'interface.

On notera également que, bien que le circuit que l'on vient de décrire est destiné à être réalisé en technologie CMOS, l'invention n'est limitée ni à cette technologie spécifique ni d'ailleurs aux types de conductivité spécifique des transistors décrits.

**Revendications**

1. Interface de test pour circuit intégré du type MOS comprenant au moins une borne commune (2) d'entrée de commande de fonction et de commande de test susceptible d être alimenteé par un signal de tension de commande de test situé hors du domaine de tensions réservé à des signaux de commande de fonction, et une borne de sortie de test, caractérisée en ce que l'interface (1) comprend un circuit parallèle en tête-bêche des trajets source-drain de deux transistors MOS ($M_1$, $M_2$) de types de conductivité opposés, ce circuit parallèle étant connecté entre une ligne (8) de tension d'alimentation ($V_{cc}$) du circuit intégré (6) et un point de potentiel (7) qui est connecté à une source de courant sensiblement constant ($M_5$, $M_6$, 10 ; $M_5$), la grille du premier transistor ($M_1$) étant reliée à ladite borne d'entrée de commande de test (2), tandis que la grille du second transistor ($M_2$) est reliée audit point de potentiel (7), et en ce que l'interface (1) comporte en outre des moyens de détection ($M_3$, $M_4$, 9, 11) capables, en réponse à une variation de la tension sur ledit point de potentiel (7) due à l'application d'une tension à ladite borne d'entrée de test (2) supérieure à ladite tension d'alimentation ($V_{cc}$), de fournir une transition logique sur ladite borne de sortie de test (5).

2. Interface de test suivant la revendication 1, caractérisée en ce que ledit premier transistor ($M_1$) est à canal N enrichi, sa source étant reliée audit point de potentiel (7), tandis que la source du second

transistor ($M_2$) à canal P enrichi est reliée à ladite ligne (8) de tension d'alimentation.

3. Interface suivant l'une quelconque des revendications 1 et 2, caractérisée en ce que ladite borne d'entrée de commande de test (2) est connectée à la masse par l'intermédiaire d'une résistance ($R_E$) d'adaptation d'impédance d'entrée.

4. Interface suivant l'une quelconque des revendications précédentes, caractérisée en ce que ladite source de courant sensiblement constant comporte un troisième transistor ($M_5$) relié par son trajet drain-source entre ledit point de potentiel (7) et la masse et de type de conductivité opposé à celui dudit second transistor ($M_2$).

5. Interface suivant la revendication 4, caractérisée en ce que la grille dudit troisième transistor ($M_5$) est reliée audit point de potentiel (7).

6. Interface suivant la revendication 4, caractérisée en ce que la grille dudit troisième transistor ($M_5$) est connectée à la grille et au drain d'un quatrième transistor ($M_6$) selon un montage à miroir de courant, ce quatrième transistor étant connecté à une source de courant (10).

7. Interface suivant la revendication 6, caractérisée en ce que la source de courant (10) fait partie du circuit intégré (6).

8. Interface suivant l'une quelconque des revendications 4 à 7, caractérisée en ce que lesdits moyens de détection comprennent le montage en série des trajets drain-source d'un cinquième ($M_3$) et d'un sixième ($M_4$) transistors ayant des types de conductivité opposés, dont le point commun de connexion (9) est relié à ladite borne de sortie de test (5), et dont les bornes d'extrémité sont reliées respectivement à ladite ligne (8) de tension d'alimentation et la masse, et en ce que les cinquième ($M_3$) et sixième ($M_4$) transistors sont agencés pour former un miroir de courant respectivement avec le second ($M_2$) et le troisième transistor ($M_5$), la grille du cinquième transistor ($M_3$) étant connectée audit point de potentiel (7), tandis que la grille du sixième transistor ($M_4$) est connectée à celle du troisième transistor ($M_5$).

9. Interface suivant la revendication 8, caractérisée en ce que les facteurs de forme $K_f(M2)$ et $K_f(M3)$)du second ($M_2$) et du cinquième transistor ($M_3$) sont choisis de manière à satisfaire la relation

$$\frac{K_f(M3)}{K_f(M2)} > 1,$$

le rapport

$$\frac{K_f(M3)}{K_f(M2)}$$

étant de préférence sensiblement supérieur à 1.

10. Interface selon la revendication 9, caractérisée en ce que les troisième ($M_5$) et sixième ($M_4$) transistors ont sensiblement le même facteur de forme :

$$K_f(M_5) \neq K_f(M_4).$$

## Claims

1. Test interface for an MOS type integrated circuit including at least one common, function command and test command input terminal (2) capable of being supplied by a test command voltage signal lying outside the voltage range reserved for function command signals and a test output terminal, characterised in that the interface (1) comprises a parallel circuit with head-to-tail connection of the source-drain paths of two MOS transistors ($M_1$, $M_2$,) of opposite types of conductivity, this parallel circuit being connected between a power supply voltage ($V_{cc}$) line (8) of the integrated circuit (6) and a potential point (7) which is connected to an approximately constant current source ($M_5$, $M_6$, 10 ; $M_5$), the grid of the first transistor ($M_1$) being connected to the said test command input terminal (2), while the grid of the second transistor ($M_2$) is connected to the said potential point (7), and in that the interface (1) also includes means of detection ($M_3$, $M_4$, 9, 11) capable, in response to a variation in the voltage on the said potential point (7) due to the application of a voltage to the said test input terminal (2) higher than the said power supply voltage ($V_{cc}$), of providing a logic transition on the said test output terminal (5).

2. Test interface according to Claim 1, characterised in that the said first transistor ($M_1$) is an enriched N channel transistor, its source being connected to the said potential point (7), while the source of the second transistor ($M_2$) of enriched P channel type is connected to the said power supply voltage line (8).

3. Interface according to either of Claims 1 and 2, characterised in that the said test command input terminal (2) is connected to ground via an input impedance matching resistor ($R_E$).

4. Interface according to any of the preceding claims, characterised in that the said approximately constant current source includes a third transistor ($M_5$) connected by its drain-source path between the said potential point (7) and ground and of conductivity type opposite to that of the said second transistor ($M_2$).

5. Interface according to Claim 4, characterised in that the grid of the said third transistor ($M_5$) is connected to the said potential point (7).

6. Interface according to Claim 4, characterised in that the grid of the said third transistor ($M_5$) is connected to the grid and to the drain of a fourth transistor ($M_6$) in a mirror-image current arrangement, this fourth transistor being connected to a current source (10).

7. Interface according to Claim 6, characterised in that the current source (10) is part of the integrated circuit (6).

8. Interface according to any of Claims 4 to 7, characterised in that the said means of detection comprize the series connection of the drain-source paths of a fifth ($M_3$) transistor and a sixth ($M_4$) transistor having opposite types of conductivity, whose common connection point (9) is connected to the said test output terminal (5), and whose end terminals are connected to the said power supply voltage line (8) and ground, respectively, and in that the fifth ($M_3$) and sixth ($M_4$) transistors are arranged to form a mirror-image current with the second ($M_2$) and third ($M_5$) transistors respectively, the grid of the fifth transistor ($M_3$) being connected to the said potential point (7), while the grid of the sixth transistor ($M_4$) is connected to that of the third transistor ($M_5$).

9. Interface according to Claim 8, characterised in that the form factors ($K_f(M2)$ and $K_f(M3)$) of the second ($M_2$) and of the fifth ($M_3$) transistors are chosen in order to satisfy the following expression

$$\frac{K_f(M3)}{K_f(M2)} > 1,$$

the ratio $K_f(M3)/K_f(M2)$ being preferably considerably greater than 1.

10. Interface according to Claim 9, characterised in that the third ($M_5$) and sixth ($M_4$) transistors have approximately the same form factor:

$K_f(M_5)$    $K_f(M_4)$.

**Patentansprüche**

1. Prüfzwischenschaltung für integrierten Schaltkreis in MOS-Technologie, bestehend aus mindestens einer gemeinsamen Eingangsklemme (2) für einen Funktionsbefehl und einen Testbefehl zur Speisung mit einem Spannungssignal des Testbefehls, das außerhalb eines Spannungsbereiches liegt, der für Funktionsbefehlsignale reserviert ist, und einer Testausgangsklemme, dadurch gekennzeichnet, daß die Zwischenschaltung (1) eine Parallelschaltung aus zwei MOS-Transistoren ($M_1$, $M_2$) entgegengesetzter Leitfähigkeit mit vertauscht geschalteten Quelle-Senkestrompfaden aufweist, daß die Parallelschaltung zwischen einer Leitung (8) einer Speisespannung ($V_{cc}$) einer integrierten Schaltung (6) und einem Potentialpunkt (7) geschaltet ist, der an eine Stromquelle ($M_5$, $M_6$, 10; $M_5$) von hoher Konstanz angeschlossen ist, daß das Gitter des ersten Transistors ($M_1$) an die Eingangsklemme (2) des Testbefehls angeschlossen ist, während das Gitter des zweiten Transistors ($M_2$) an den Potentialpunkt (7) angeschlossen ist und daß die Zwischenschaltung (1) eine Detektorschaltung ($M_3$, $M_4$, 9, 11) aufweist, die in der Lage ist, abhängig von einer Spannungsänderung an dem Potentialpunkt (7) infolge des Auftretens einer Spannung an der Testeingangsquelle (2), die größer ist als die Speisespannung ($V_{cc}$), einen logischen Übergang an der Testausgangsklemme (5) zu liefern.

2. Prüfzwischenschaltung nach Anspruch 1, dadurch gekennzeichnet, daß der erste Transistor ($M_1$) einen angereicherten N-Kanal aufweist, wobei seine Quelle an den Potentialpunkt (7) angeschlossen ist, während die Quelle des zweiten Transistors ($M_2$) mit einem angereicherten P-Kanal an die Speisespannungsleitung (8) angeschlossen ist.

3. Zwischenschaltung nach einem der Ansprüche 1 und 2, dadurch gekennzeichnet, daß die Eingangsklemme (2) des Testbefehls über einen Widerstand ($R_E$) mit angepaßter Eingangsimpedanz an Masse angeschlossen ist.

4. Zwischenschaltung nach einem der vorhergehenden Ansprüche, dadurch gekennzeichnet, daß die Stromquelle hoher Konstanz einen dritten Transistor ($M_5$) aufweist, der über seinen Senke-Quelle-Strompfad zwischen dem Potentialpunkt (7) und Masse angeschlossen ist und dessen Leitfähigkeit der des zweiten Transisotrs ($M_2$) entgegengesetzt ist.

5. Zwischenschaltung nach Anspruch 4, dadurch gekennzeichnet, daß das Gitter des dritten Transistors ($M_5$) an den Potentialpunkt (7) angeschlossen ist.

6. Zwischenschaltung nach Anspruch 4, dadurch gekennzeichnet, daß das Gitter des dritten Transistors ($M_5$) an das Gitter und an die Senke eines vierten Transistors ($M_6$) angeschlossen ist, der spiegelbildlich geschaltet ist, wobei der vierte Transistor an eine Stromquelle (10) angeschlossen ist.

7. Zwischenschaltung nach Anspruch 6, dadurch gekennzeichnet, daß die Stromquelle (10) Teil der integrierten Schaltung (6) ist.

8. Zwischenschaltung nach einem der Ansprüche 4 bis 7, dadurch gekennzeichnet, daß die Detektorschaltung eine Serienschaltung der Senke-Quelle-Strompfade eines fünften Transistors ($M_3$) und eines sechsten Transistors ($M_4$) von entgegengesetzter Leitfähigkeit aufweist, deren Verbindungsschaltpunkt (9) an die Testausgangsklemme (5) angeschlossen ist und deren äußere Anschlüsse an die Speisespannungsleitung (8) bzw. an Masse angeschlossen sind, und daß der fünfte Transistor ($M_3$) und der sechste Transistor ($M_4$) jeweils spiegelbildlich zu dem zweiten Transistor ($M_2$) und dem dritten Transistor ($M_5$) angeordnet sind, wobei das Gitter des fünften Transistors ($M_3$) an den Potentialpunkt (7) angeschlossen ist, während das Gitter des sechsten Transitors ($M_4$) mit dem Gitter des dritten Transistors ($M_5$) verbunden ist.

9. Zwischenschaltung nach Anspruch 8, dadurch gekennzeichnet, daß die Formfaktoren $K_f(M2)$ und $K_f(M3)$ des zweiten Transistors ($M_2$) und des fünften Transistors ($M_3$) entsprechend der Beziehung

$$\frac{K_f(M3)}{K_f(M2)} > 1$$

gewählt wird, wobei der Wert

$$\frac{K_f(M3)}{K_f(M2)}$$

vorzugsweise erheblich größer als 1 ist.

10. Zwischenschaltung nach Anspruch 9, dadurch gekennzeichnet, daß der dritte Transistor ($M_5$) und der sechste Transistor ($M_4$) im wesentlichen den gleichen Formfaktor aufweisen:

$K_f(M_5) \neq K_f(M_4)$.

FIG.1

FIG.:3

FIG.: 2

FIG.: 4A

DRAIN GRILLE SOURCE

L LARGEUR

ℓ LONGUEUR

FIG.: 4B

11

FIG.:5

FIG.:6